# FASCICULE DE BREVET EUROPEEN

(11) **EP 0 626 696 B1**
(45) Date de publication et mention de la délivrance du brevet: **11.11.1998**
(21) Numéro de dépôt: 94410038.7
(22) Date de dépôt: 20.05.1994
(51) Int. Cl.: G11C 11/409, G11C 7/00

(54) **Mémoire dynamique avec des cellules de référence**
Dynamischer Speicher mit Referenzzellen
Dynamic memory with reference cells

(30) Priorité: 24.05.1993 FR 9306533
(43) Date de publication de la demande: 30.11.1994
(73) Titulaire: SGS-THOMSON MICROELECTRONICS S.A., 94250 Gentilly (FR)
(72) Inventeur: Harrand, Michel, F-38120 Saint Egreve (FR); Runtz, Michel, F-38100 Grenoble (FR)
(74) Mandataire: de Beaumont, Michel

(56) Documents cités:
- EP-A- 0 068 894
- EP-A- 0 163 951
- US-A- 4 363 111

## Description

La présente invention concerne les mémoires dynamiques, en particulier celles du type à cellules factices ou de référence.

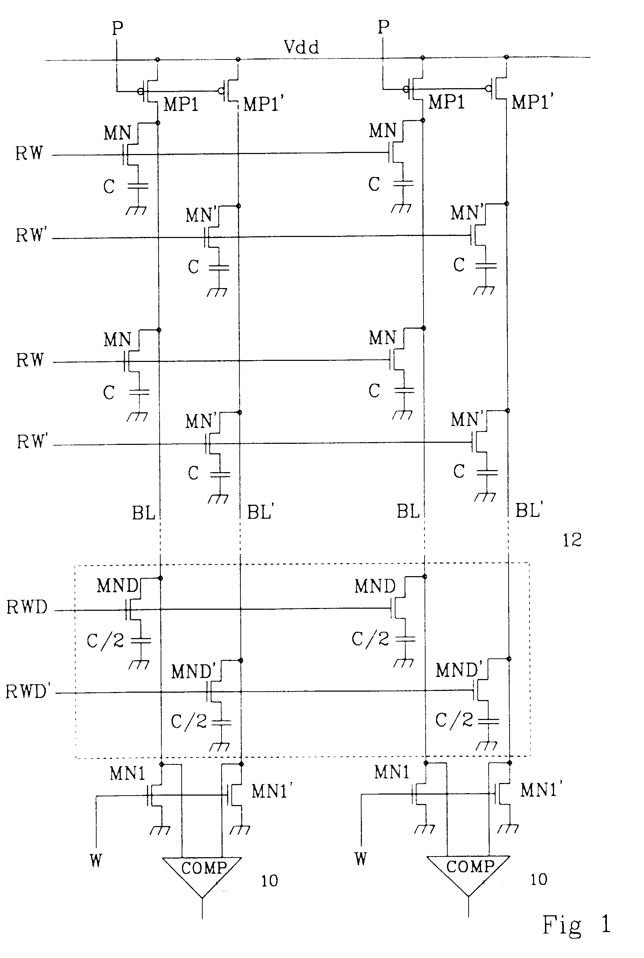

La figure 1 représente partiellement une telle mémoire dynamique. Cette mémoire dynamique comprend une pluralité de cellules mémoire comprenant chacune un transistor MOS à canal N MN ou MN' permettant de relier une capacité C entre un potentiel de référence, tel que la masse, et une ligne de bit BL ou BL'. Les cellules sont disposées en colonnes, correspondant aux lignes de bit BL et BL', et en rangées. Les colonnes sont regroupées par couples. Ci-après, on qualifie par "pair" un élément associé à l'une quelconque des colonnes d'un couple, et par "impair" un élément associé à l'autre colonne du couple.

Une rangée paire de cellules comprend des cellules MN/C qui ne sont reliées qu'aux lignes de bit paires BL. Une rangée impaire de cellules comprend des cellules MN'/C qui ne sont reliées qu'aux lignes de bit impaires BL'. Les grilles des transistors MN ou MN' d'une rangée sont reliées à une ligne de sélection RW ou RW', respectivement.

Les lignes BL et BL' d'un couple de colonnes sont reliées à un potentiel haut Vdd par des transistors MOS à canal P respectifs MP1 et MP1', et à la masse par des transistors MOS à canal N respectifs MN1 et MN1'. Les grilles des transistors MP1 et MP1' sont reliées à une ligne de précharge P, et les grilles des transistors MN1 et MN1' sont reliées à une ligne d'écriture W. Chaque couple de colonnes est associé à des lignes P et W spécifiques permettant de sélectionner le couple de colonnes. En outre, chaque couple de lignes BL et BL' est relié à l'entrée d'un comparateur 10.

On a représenté dans un cadre en pointillés 12 une rangée paire et une rangée impaire de cellules dites factices ou de référence. Ces cellules de référence sont identiques aux cellules précédentes, sauf que leur capacité, C/2, est de valeur moitié de celle des capacités C. Les transistors de la rangée paire de cellules de référence sont notés MND, et leurs grilles sont reliées à une ligne de sélection RWD. Les transistors de la rangée impaire de cellules de référence sont notés MND', et leurs grilles sont reliées à une ligne de sélection RWD'.

Pour écrire un "0" dans une cellule, on active la ligne RW ou RW' correspondante et la ligne W du couple de colonnes correspondant. Les lignes BL et BL' passent à 0 et la capacité C de la cellule validée est déchargée.

Pour écrire un "1" dans une cellule, on active la ligne RW ou RW' correspondante et la ligne P du couple de colonnes correspondant. La tension sur les lignes BL et BL' passe à Vdd et la capacité C de la cellule validée est chargée à la tension Vdd, à la tension de seuil près des transistors MN ou MN'.

Avant d'effectuer une lecture d'une cellule, on effectue une décharge des capacités C/2 des cellules de référence. Ceci peut être fait par un cycle d'écriture d'un "0" dans ces cellules.

Ensuite, pour lire la cellule mémoire, par exemple une cellule paire, on effectue d'abord une précharge au potentiel Vdd des lignes BL et BL' du couple de colonnes correspondant en activant la ligne P associée. Les lignes BL et BL' présentent des capacités importantes qui se trouvent ainsi chargées au potentiel Vdd. Ensuite, la ligne de sélection RW de la rangée paire comprenant la cellule paire à lire est activée en même temps que la ligne RWD' de sélection des cellules de référence impaires. Ainsi, on relie à la ligne BL une capacité C et à la ligne BL' une capacité C/2. La capacité C/2 ayant préalablement été déchargée, il se produit un transfert de charge entre la ligne BL' vers la capacité de référence C/2. La capacité de la ligne BL' est grande par rapport à celle de C/2 et la tension sur cette ligne ne chute que d'une centaine de millivolts environ.

Si la capacité C de la cellule à lire est chargée, c'est-à-dire si la cellule est à "1", l'état de la ligne BL ne change pas. Ainsi, la tension sur la ligne BL' est inférieure à la tension sur la ligne BL et le comparateur 10 bascule à un premier état indiquant que la cellule lue est à "1".

Si la capacité C de la cellule lue est déchargée (la cellule est à "0") il se produit également un transfert de charge entre la ligne BL et la capacité C. La capacité C étant deux fois plus importante que la capacité C/2 de la cellule de référence, la chute de tension sur la ligne BL est deux fois plus importante que celle sur la ligne BL'. Ainsi, la tension sur la ligne BL devient inférieure à celle sur la ligne BL' et le comparateur 10 bascule à un deuxième état indiquant que la cellule lue est à "0".

Une difficulté de fabrication d'une telle mémoire dynamique réside dans la réalisation d'un rapport suffisamment précis entre les capacités C et les capacités C/2. Dans des technologies destinées à réaliser seulement des mémoires dynamiques, cette difficulté a été surmontée à la suite d'études et d'essais consacrés à établir des règles de dimensionnement des capacités C et C/2. Toutefois, si l'on transpose ces règles à des technologies distinctes, on n'obtient pas les mêmes résultats, à tel point que les capacités C et C/2 peuvent avoir des valeurs proches. Ceci est particulièrement gênant si l'on veut inclure des mémoires dynamiques dans divers circuits, non exclusivement destinés à servir de mémoires, tels que des circuits de traitement de signal, puisque ces divers circuits peuvent être réalisés dans une multitude de technologies distinctes auxquelles on ne peut appliquer les mêmes règles de dimensionnement des capacités.

Cette difficulté est aussi traitée dans les documents EP-A-0 163 951 et US-A-4 363 111. Selon ces documents on propose de faire les cellules de référence de même capacité que les cellules mémoire et, selon EP-A-0 163 951, de prolonger la ligne de bit à laquelle la cellule de référence sélectionée est connectée, ou selon US-A-4 393 111, de partager chaque cellule de référence entre deux lignes de bit.

Un objet de la présente invention est de prévoir une mémoire dynamique à cellules de référence, dont la structure puisse être utilisée, sans adaptation, dans n'importe quelle technologie.

Cet objet est atteint en remplaçant les capacités des cellules de référence par des capacités de même valeur que celles des cellules mémoire et en chargeant ces capacités de référence, avant une lecture, à un potentiel proche de la moitié du potentiel d'alimentation. La présente invention prévoit notamment des moyens spécifiques pour charger les capacités de référence à la valeur souhaitée.

La présente invention prévoit plus particulièrement une mémoire dynamique comprenant : une pluralité de cellules à capacité reliées par colonnes à des lignes de bit et par rangées à des lignes de sélection, une colonne paire de chaque couple de colonnes contenant des cellules appartenant respectivement à des rangées paires, et la colonne impaire de chaque couple de colonnes contenant des cellules appartenant respectivement à des rangées impaires ; une rangée paire et une rangée impaire contenant des cellules de référence, les cellules des autres rangées étant des cellules mémoire ; des moyens pour précharger les lignes de bit à un état prédéterminé avant une lecture ; des moyens pour sélectionner, lors d'une lecture, la rangée impaire de cellules de référence en même temps que l'une quelconque des rangées paires de cellules mémoire ; et un comparateur associé à chaque couple de colonnes, recevant les deux lignes de bit du couple de colonnes. Selon l'invention, les capacités des cellules de référence sont égales aux capacités des cellules mémoire, et il est prévu des moyens pour, avant une lecture d'une cellule mémoire d'une rangée paire, relier la ligne de sélection de la rangée impaire de cellules de référence à un élément ayant la même capacité qu'une ligne de sélection, mais préchargée à l'état opposé de celui de la ligne de sélection de la rangée impaire de cellules de référence.

Selon un mode de réalisation de la présente invention, ledit élément est une ligne de sélection fictive ayant les mêmes caractéristiques que les autres lignes de sélection.

Selon un mode de réalisation de la présente invention, la mémoire comprend deux premiers transistors pour relier respectivement les lignes de sélection des cellules de référence à la ligne de sélection fictive, et des moyens pour commander l'un ou l'autre de ces premiers transistors lorsqu'une précharge des lignes de bit est effectuée.

Selon un mode de réalisation de la présente invention, la mémoire comprend des deuxièmes transistors permettant d'initialiser les capacités des cellules de référence, et des moyens pour commander les deuxièmes transistors de la rangée impaire de cellules de référence après une sélection d'une rangée paire quelconque de cellules mémoire.

Selon un mode de réalisation de la présente invention, la mémoire comprend, pour chaque ligne de sélection de cellules de référence, des troisième et quatrième transistors permettant respectivement de ramener cette ligne de sélection à un état actif et à un état inactif, et des moyens pour commander le troisième transistor de la rangée impaire lorsqu'une rangée paire de cellules mémoire est sélectionnée, et pour commander le quatrième transistor de la rangée impaire après la sélection de la rangée paire de cellules mémoire.

Selon un mode de réalisation de la présente invention, la mémoire comprend un cinquième transistor permettant de ramener la ligne de sélection fictive à un état actif, et des moyens pour commander ce cinquième transistor lorsqu'une rangée quelconque est sélectionnée.

Ces objets, caractéristiques et avantages ainsi que d'autres de la présente invention seront décrits en détail dans la description suivante de modes de réalisation particuliers faite en relation avec les figures jointes parmi lesquelles :
la figure 1, précédemment décrite, représente partiellement une structure de mémoire dynamique classique ;
la figure 2 représente partiellement une structure d'un mode de réalisation de mémoire dynamique selon la présente invention ; et
la figure 3 illustre un chronogramme de cycles de lecture d'une cellule dans une mémoire dynamique selon la présente invention.

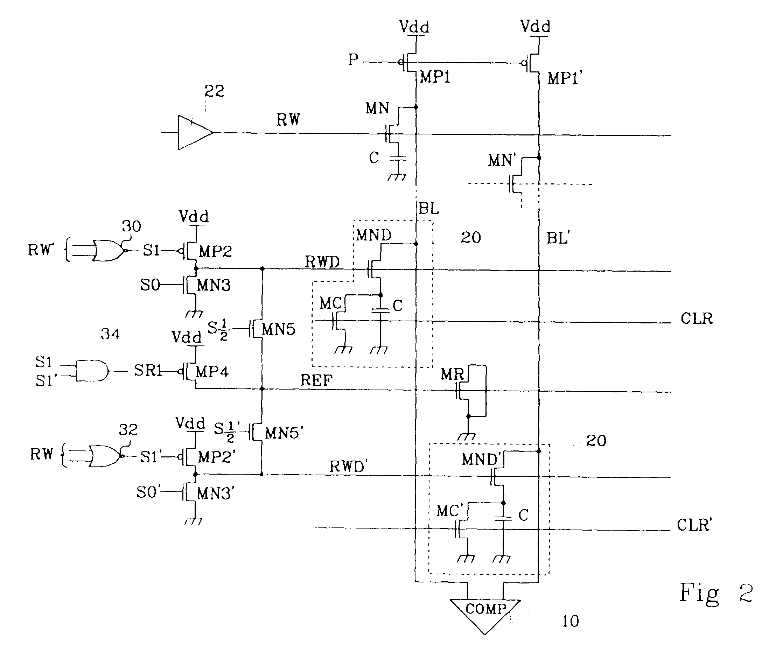

La figure 2 représente de nouveau certains des éléments de la figure 1, désignés par des mêmes références. Selon l'invention, dans chaque cellule de référence, entourée par un cadre en pointillés 20, on a remplacé la capacité C/2 par une capacité C de même valeur que les capacités des autres cellules de la mémoire. Il est particulièrement aisé de réaliser des capacités de même valeur dans un circuit intégré. Il suffit généralement qu'elles aient la même forme et la même taille.

Aux deux lignes de sélection RWD et RWD' des cellules de référence, est associée une ligne de sélection factice REF qui présente les mêmes caractéristiques capacitives que les lignes RWD et RWD'. Pour cela, la ligne REF est reliée aux grilles de transistors MR non utilisés, identiques aux transistors MND et MND'. Il est prévu sur la ligne REF un transistor MR par couple de colonnes. Le drain et la source des transistors MR sont reliés à la masse.

Pour charger les capacités des cellules de référence à Vdd/2, on prévoit, selon l'invention, de les décharger préalablement puis de charger la ligne REF au potentiel Vdd et de relier ensuite cette ligne REF à la ligne RWD ou RWD', qui est chargée au potentiel 0. Les charges s'équilibrent entre les lignes REF et RWD ou RWD' et, puisque leur capacité est la même, leurs potentiels passent à Vdd/2. Les transistors MND et MND' sont montés en suiveurs et appliquent leur potentiel de grille Vdd/2 sur leurs capacités C, à la tension de seuil près des transistors MND ou MND'.

On pourrait envisager d'appliquer le potentiel Vdd/2 sur les grilles de transistors MND ou MND' par un pont de résistances. Toutefois, une résistance est délicate et encombrante à réaliser en technologie MOS, qui est la technologie employée pour les mémoires dynamiques. En outre, un tel pont de résistances consommerait un courant de repos incertain et variable d'un circuit à un autre. On cherche, en technologie CMOS, à éviter une consommation de courant de repos puisqu'un moyen de déceler un circuit CMOS défectueux est de détecter qu'il consomme un courant au repos.

Les cellules de référence comprennent en outre un transistor relié en parallèle sur la capacité C. Ce transistor est noté MC pour les cellules de référence paires et MC' pour les cellules de référence impaires. La grille des transistors MC est commandée par une ligne d'effacement CLR et les grilles des transistors MC' sont commandées par une ligne d'effacement CLR'. Bien entendu, il importe que la présence des transistors MC et MC' n'affecte pas la valeur des capacités C qu'ils commandent. Pour cela, les transistors MN et MC (ou MN' et MC') d'une cellule de référence sont réalisés de part et d'autre des armatures de la capacité C, dans le plan des armatures.

La figure 2 représente également des éléments de commande des diverses lignes de sélection. Les lignes de sélection RW et RW' sont commandées de manière classique par un suiveur 22, lui-même commandé par un circuit de décodage classique, non représenté. La ligne RWD est reliée au potentiel Vdd par un transistor MP2 et à la masse par un transistor MN3. Les grilles des transistors MP2 et MN3 sont respectivement commandées par des lignes S1 et S0. De même, la ligne RWD' est reliée au potentiel haut Vdd par un transistor MP2' et au potentiel bas par un transistor MN3'. Les grilles des transistors MP2' et MN3' sont commandées respectivement par des lignes S1' et S0'. La ligne de sélection fictive REF est reliée au potentiel haut Vdd par un transistor MP4 dont la grille est commandée par une ligne SR1. Un transistor MN5 relie ensemble les lignes RWD et REF, et un transistor MN5' relie ensemble les lignes RWD' et REF. Les grilles des transistors MN5 et MN5' sont commandées respectivement par des lignes S½ et S½'.

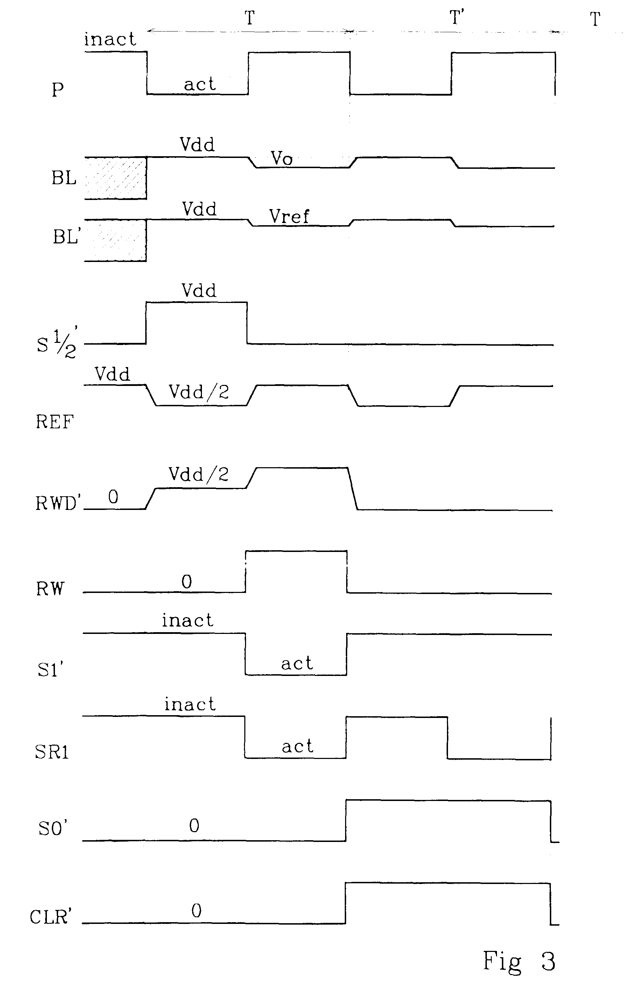

La figure 3 représente les états de diverses lignes du circuit de la figure 2 lors de deux cycles de lecture consécutifs se produisant pendant des intervalles de temps respectifs T et T'. L'intervalle T correspond à un cycle de lecture d'une cellule paire et l'intervalle T' à un cycle de lecture d'une cellule impaire. Selon un mode de réalisation, c'est en alternant les cycles de lecture de cellules paires avec les cycles de lecture de cellules impaires que l'on lit des données dans une mémoire dynamique à oellules de référence. Un cycle de lecture se décompose en une phase de précharge des lignes de bit BL et BL', et en une phase de lecture proprement dite.

Pendant le cycle de précharge, au début de l'intervalle T, la ligne P est mise à un niveau actif ("0"). Il en résulte que les lignes de bit BL et BL' sont chargées au potentiel Vdd (l'état initial des lignes BL et BL' est quelconque).

Pendant cette phase de précharge, on active également la ligne S½', ce qui relie entre elles la ligne de sélection factice REF et la ligne de sélection RWD'. La ligne REF était initialement au potentiel Vdd et la ligne RWD' au potentiel 0, et étaient toutes les deux flottantes. Il en résulte, pendant cette phase de précharge, que la tension de la ligne REF chute à Vdd/2 et que la tension de la ligne de sélection RWD' croît jusqu'à Vdd/2, puisque ces deux lignes présentent la même capacité. Comme les transistors des cellules de référence sont montés en suiveur, la capacité C de la cellule de référence impaire sélectionnée se charge à Vdd/2, à la tension seuil près du transistor MND'.

Ensuite, commence la phase de lecture par la désactivation de la ligne de précharge P et l'activation de la ligne de sélection RW de la rangée paire contenant la cellule à lire. En même temps que la ligne RW est activée, on active la ligne S1' qui entraîne la mise au potentiel Vdd de la ligne RWD'. La capacité C de la cellule à lire se trouve reliée à la ligne BL et la capacité C de la cellule de référence à la ligne BL', ces lignes BL et BL' étant flottantes mais préalablement chargées au potentiel Vdd lors de la phase de précharge.

Si la capacité C de la cellule paire à lire était déjà chargée à Vdd (la cellule était à "1") la tension sur la ligne BL ne varie pas, comme cela est représenté en pointillés. Par contre, si cette capacité C était déchargée, les charges s'équilibrent entre cette capacité et la ligne BL et la tension sur la ligne BL chute jusqu'à une tension V0 inférieure de quelques centaines de millivolts à la tension Vdd.

En même temps, les charges de la ligne BL' et de la capacité C de la cellule de référence impaire s'équilibrent. Toutefois, comme la tension aux bornes de la capacité de la cellule de référence était sensiblement à Vdd/2, la tension sur la ligne BL' chute jusqu'à une tension Vref sensiblement à mi-distance entre la tension Vdd et la tension V0.

Le comparateur 10, recevant les lignes BL et BL', bascule à un premier état si la cellule lue était à "1", puisque, alors, la tension sur la ligne BL était supérieure à la tension Vref, ou bascule à un deuxième état si la cellule lue était à "0", puisqu'alors la tension sur la ligne BL était inférieure à la tension Vref.

Pendant la phase de lecture, la ligne SR1 est également activée, ce qui permet de rétablir l'état initial à Vdd de la ligne de sélection factice REF. Ce signal SR1 est activé à chaque phase de lecture, qu'il s'agisse d'une lecture d'une cellule paire ou d'une cellule impaire.

Un cycle de lecture T' d'une cellule impaire, qui est par exemple dans le même couple de colonnes que la cellule paire que l'on vient de lire, comnence dès la fin du cycle T. Les signaux P, BL, BL', REF et SR1 sont similaires à ceux du cycle T précédent.

Pendant le cycle T', les signaux S½', RWD', RW et S1' restent inactifs et ce sont les signaux S½, RWD, RW' et S1 (non représentés) qui se comportent respectivement de la même manière.

A la fin de chaque cycle de lecture, par exemple du cycle T, il faut ramener la ligne RWD' à son état inactif "0", ce qui est fait en activant le signal S0' pendant le cycle T' suivant. Il faut en outre décharger la capacité C de la cellule de référence qui vient d'être utilisée, ce qui est fait, toujours pour le cycle T, en activant la ligne d'effacement CLR' pendant le cycle T' suivant.

La présence des transistors d'effacement MC est particulièrement utile, puisque ces transistors déchargent les capacités C des cellules de référence par exemple paires pendant que l'on se sert des cellules de référence impaires pour la lecture de cellules mémoire paires. Ceci permet d'enchaîner deux cycles de lecture sans temps d'attente. Ces transistors d'effacement pourraient être omis, mais on doit alors décharger les capacités des cellules de référence par un cycle d'écriture d'un "0" dans ces cellules, ce qui représente une perte de temps.

La réalisation d'un décodeur permettant de fournir les signaux de commande des cellules de référence selon l'invention est à la portée de l'homme du métier. Par exemple, comme cela est représenté à la figure 2, le signal S1 est obtenu à l'aide d'une porte NON-OU 30 combinant tous les signaux RW' ; le signal S1' est obtenu à l'aide d'une porte NON-OU 32 combinant tous les signaux RW ; et le signal SR1 est obtenu par une porte ET 34 combinant les signaux S1 et S1'. Les signaux S½ et S½' sont obtenus en combinant le signal de précharge P et un signal non décrit servant classiquement à indiquer si l'on effectue une lecture de cellules paires ou de cellules impaires. Les signaux S0' et CLR' peuvent être égaux au signal servant à indiquer une lecture paire ou impaire, ou être obtenus en divisant par 2 la fréquence du signal SR1.

## Revendications

1. Mémoire dynamique comprenant
- une pluralité de cellules (MN, MN',C) à capacité (C) reliées par colonnes à des lignes de bit (BL, BL') et par rangées à des lignes de sélection (RW, RW'), une colonne paire de chaque couple de colonnes contenant des cellules (MN, C) appartenant respectivement à des rangées paires, et la colonne impaire de chaque couple de colonnes contenant des cellules (MN', C) appartenant respectivement à des rangées impaires ;
- une rangée paire et une rangée impaire contenant des cellules de référence (MND, MND', C), les cellules des autres rangées étant des cellules mémoire ;
- des moyens (MP1, MP1') pour précharger les lignes de bit (BL, BL') à un état prédéterminé (Vdd) avant une lecture ;
- des moyens pour sélectionner, lors d'une lecture, la rangée impaire de cellules de référence en même temps que l'une quelconque des rangées paires de cellules mémoire ;
- un comparateur (10) associé à chaque couple de colonnes, recevant les deux lignes de bit du couple de colonnes ; et
- les capacités (C) des cellules de référence sont égales aux capacités des cellules mémoire,
caractérisée en ce qu'il est prévu des moyens pour, avant une lecture d'une cellule mémoire d'une rangée paire, relier la ligne de sélection (RWD, RWD') de la rangée impaire de cellules de référence à un élément (REF) ayant la même capacité qu'une ligne de sélection, mais préchargée à l'état opposé de celui de la ligne de sélection de la rangée impaire de cellules de référence.

2. Mémoire dynamique selon la revendication 1, caractérisée en ce que ledit élément est une ligne de sélection fictive ayant les mêmes caractéristiques que les autres lignes de sélection.

3. Mémoire dynamique selon la revendication 2, caractérisée en ce qu'elle comprend deux premiers transistors (MN5, MN5') pour relier respectivement les lignes de sélection (RWD, RWD') des cellules de référence à la ligne de sélection fictive (REF), et des moyens pour commander l'un ou l'autre de ces premiers transistors lorsqu'une précharge des lignes de bit (BL, BL') est effectuée.

4. Mémoire dynamique selon la revendication 1, caractérisée en ce qu'elle comprend des deuxièmes transistors (MC, MC') permettant d'initialiser les capacités des cellules de référence, et des moyens pour commander les deuxièmes transistors de la rangée impaire de cellules de référence après une sélection d'une rangée paire quelconque de cellules mémoire.

5. Mémoire dynamique selon la revendication 1, caractérisée en ce qu'elle comprend, pour chaque ligne de sélection de cellules de référence, des troisième et quatrième transistors (MP2, MP2' ; MN3, MN3') permettant respectivement de ramener cette ligne de sélection à un état actif (Vdd) et à un état inactif (0), et des moyens pour commander le troisième transistor de la rangée impaire lorsqu'une rangée paire de cellules mémoire est sélectionnée, et pour commander le quatrième transistor de la rangée impaire après la sélection de la rangée paire de cellules mémoire.

6. Mémoire dynamique selon la revendication 2, caractérisée en ce qu'elle comprend un cinquième transistor (MP4) permettant de ramener la ligne de sélection fictive (REF) à un état actif (Vdd), et des moyens pour commander ce cinquième transistor lorsqu'une rangée quelconque est sélectionnée.

## Claims

1. A dynamic memory including:
- a plurality of cells (MN, MN', C) including capacitors (C) connected by columns to bit lines (BL, BL') and by rows to selection lines (RW, RW'), an even column of each pair of columns containing cells (MN, C) of respective even rows, and an odd column of each pair of columns containing cells (MN', C) of respective odd rows;
- an even row and an odd row containing reference cells (MND, MND', C), the cells of the other rows being memory cells;
- means (MP1, MP1') for precharging the bit lines (BL, BL') at a predetermined state (Vdd) before reading;
- means for selecting, when reading, the odd row of the reference cells simultaneously with any one of the even rows of the memory cells; and
- a comparator (10) associated with each pair of columns, receiving the two bit lines of the pair of columns;
- the capacitors (C) of the reference cells have the same value as the capacitors of the memory cells; characterized in that means are provided for, prior to reading a memory cell of an even row, connecting the selection line (RWD, RWD') of the odd row of reference cells to an element (REF) having the same capacitance as a selection line, but which is precharged at the state opposite to the state of the selection line of the odd row of the reference cells.

2. The dynamic memory of claim 1, wherein said element is a dummy selection line having the same characteristics as the other selection lines.

3. The dynamic memory of claim 2, including two first transistors (MN5, MN5') to connect respectively the selection lines (RWD, RWD') of the reference cells to the dummy selection line (REF), and means to control either one of said first transistors when the bit lines (BL, BL') are precharged.

4. The dynamic memory of claim 1, including second transistors (MC, MC') to initialize the capacitors of the reference cells, and means to control the second transistors of the odd row of reference cells once an arbitrary even row of memory cells has been selected.

5. The dynamic memory of claim 1, including, for each selection line of the reference cells, third and fourth transistors (MP2, MP2'; MN3, MN3') to respectively restore said selection line to an active state (Vdd) and an inactive state (0), and means to control the third transistor of the odd row when an even row of memory cells is selected, and to control the fourth transistor of the odd row once the even row of the memory cells has been selected.

6. The dynamic memory of claim 2, including a fifth transistor (MP4) to restore the dummy selection line (REF) to an active state (Vdd), and means to control this fifth transistor when an arbitrary row is selected.

## Patentansprüche

1. Dynamischer Speicher, welcher umfaßt:
- eine Mehrzahl von spaltenweise mit Bit-Leitungen (BL, BL') und zeilenweise mit Auswahl- bzw. Ansteuerleitungen (RW, RW') verbundenen Zellen (MN, MN', C) mit Kapazität (C), wobei jeweils eine gerade Spalte jedes Spaltenpaars Zellen (MN, C) enthält, welche geraden Zeilen angehören, und die ungerade Spalte jedes Spaltenpaars Zellen (MN', C) enthält, die entsprechend ungeraden Zeilen angehören;
- eine gerade und eine ungerade Zeile, welche Referenzzellen (MND, MND', C) enthalten, während die Zellen der anderen Zeilen Speicherzellen sind;
- Mittel (MP1, MP1'), um die Bit-Leitungen (BL, BL') vor einem Lesevorgang in einen vorgegebenen Zustand (Vdd) aufzuladen bzw. vorzubereiten;
- Mittel, um bei einem Lesevorgang die ungerade Zeile von Referenzzellen gleichzeitig mit einer beliebigen der geraden Zeilen von Speicherzellen anzusteuern;
- einen jeweils jedem Spaltenpaar zugeordneten Komparator (10), der an seinem Eingang die beiden Bit-Leitungen des Spaltenpaars aufnimmt;
- wobei die Kapazitäten (C) der Referenzzellen gleich groß wie die Kapazitäten der Speicherzellen sind,
**dadurch gekennzeichnet,** daß
Mittel vorgesehen sind, um vor dem Lesen einer Speicherzelle einer geraden Zeile die Ansteuerleitung (RWD, RWD') der ungeraden Zeile von Referenzzellen mit einem Element (REF) zu verbinden, das die gleiche Kapazität wie eine Ansteuerleitung besitzt, jedoch in einen Zustand vorgeladen bzw. vorbereitet ist, der dem der Ansteuerleitung der ungeraden Zeile von Referenzzellen entgegengesetzt ist.

2. Dynamischer Speicher nach Anspruch 1,
dadurch gekennzeichnet, daß das genannte Element eine fiktive oder Blind-Ansteuerleitung mit denselben Eigenschaften wie die anderen Ansteuerleitungen ist.

3. Dynamischer Speicher nach Anspruch 2,
dadurch gekennzeichnet, daß er zwei erste Transistoren (MN5, MN5') aufweist, um jeweils die Ansteuerleitungen (RWD,RWD') der Referenzzellen mit der fiktiven bzw. Schein-Ansteuerleitung (REF) zu verbinden, und daß er Mittel zur Steuerung des einen oder des anderen dieser ersten Transistoren aufweist, nachdem eine Vor-Aufladung bzw. Vorbereitung der Bit-Leitungen (BL, BL') erfolgt ist.

4. Dynamischer Speicher nach Anspruch 1,
dadurch gekennzeichnet, daß er zweite Transistoren (MC, MC') aufweist, welche eine Initialisierung der Kapazitäten der Referenzzellen gestatten, sowie Mittel zur Steuerung der zweiten Transistoren der ungeraden Zeile von Referenzzellen nach einer Ansteuerung einer beliebigen geraden Zeile von Speicherzellen.

5. Dynamischer Speicher nach Anspruch 1,
dadurch gekennzeichnet, daß er für jede Ansteuerleitung von Referenzzellen dritte und vierte Transistoren (MP2, MP2'; MN3, MN3') aufweist, mittels welcher diese Ansteuerleitung in einen aktiven Zustand (Vdd) bzw. in einen inaktiven Zustand (0) zurückgebracht werden kann, sowie Mittel zur Steuerung des dritten Transistors der ungeraden Zeile, nachdem eine gerade Zeile von Speicherzellen angesteuert wurde, und zur Steuerung des vierten Transistors der ungeraden Zeile nach der Ansteuerung der geraden Zeile von Speicherzellen.

6. Dynamischer Speicher nach Anspruch 2,
dadurch gekennzeichnet, daß er einen fünften Transistor (MP4) aufweist, um die fiktive oder Blind-Ansteuerleitung (REF) in einen aktiven Zustand (Vdd) zu verbringen, sowie Mittel zur Steuerung dieses fünften Transistors, sobald eine beliebige Zeile angesteuert wurde.
